# EUROPÄISCHE PATENTSCHRIFT

(11) **EP 2 878 494 B1**
(45) Veröffentlichungstag und Bekanntmachung des Hinweises auf die Patenterteilung: **27.03.2019**
(21) Anmeldenummer: 14194762.2
(22) Anmeldetag: 25.11.2014
(51) Int. Cl.: B60R 16/023, H05K 5/00, H05K 7/14, H01R 13/428, H01R 13/52

(54) **Gehäuse für wenigstens ein elektrisches Bauteil**
Housing for at least one electrical component
Boîtier pour au moins un élément électrique

(30) Priorität: 28.11.2013 DE 102013113200
(43) Veröffentlichungstag der Anmeldung: 03.06.2015
(73) Patentinhaber: Huf Hülsbeck & Fürst GmbH & Co. KG, 42551 Velbert (DE)
(72) Erfinder: BUSS, Wolfgang, 42697 Solingen (DE)
(74) Vertreter: Vogel, Andreas

(56) Entgegenhaltungen:
- EP-A1- 1 814 764
- EP-A1- 2 623 378
- WO-A1-2012/031808
- WO-A1-2013/056956
- WO-A2-2012/010152
- DE-A1- 3 310 477
- DE-A1- 10 339 159

## Beschreibung

Die vorliegende Erfindung betrifft ein Gehäuse für wenigstens ein elektromechanisches Bauteil, zur Anbringung in oder an einem Fahrzeug, sowie ein Schaltbauteil mit einem Gehäuse zur Anbringung an einem Fahrzeug und ein Verfahren für die Befestigung eines Schaltbauteils an der Karosserie eines Fahrzeugs.

Es ist bekannt, dass in einem Fahrzeug Gehäuse befestigt werden sollen, welche elektronische Bauteile aufweisen. Bei den elektronischen Bauteilen handelt es sich dabei häufig um elektromechanische Schaltbauteile, also vom Insassen des Fahrzeugs bedienbare Schaltelemente. Diese Gehäuse sind häufig derart ausgebildet, dass sie auch widrigen Umweltbedingungen standhalten müssen. Neben einer Anordnung im Innenraum kommen dabei auch Anordnungen an der Außenseite der Karosserie, z. B. im Bereich der Türgriffe oder der Öffnungsmechanik für den Kofferraum in Frage.

Um die bekannten elektrischen Bauteile durch Gehäuse zu schützen, werden diese in bekannter Weise mit der Karosserie zur Befestigung verschraubt. Dies bringt diverse Nachteile mit sich. Zum einen ist durch die Notwendigkeit einer Lasche für die Verschraubung ein zusätzlicher Platzbedarf notwendig. Dies führt zu einem größeren Gehäuse und neben dem Platzverbrauch auch zu mehr Gewicht. Die Verwendung von Schrauben ist ebenfalls ein Faktor, welcher das Gewicht bekannter Gehäuselösungen vergrößert. Nicht zuletzt ist der Aufwand der Verschraubung selbst bei der Montage des Gehäuses an der Karosserie erhöht, und führt zu einem höheren Zeitaufwand mit damit einhergehenden höheren Kosten bei der Fertigung.

Es ist Aufgabe der vorliegenden Erfindung, die voranstehend beschriebenen Nachteile zumindest teilweise zu beheben. Insbesondere ist es Aufgabe der vorliegenden Erfindung, in kostengünstiger und einfacher Weise die Befestigung eines elektrischen Bauteils in einem Fahrzeug zu gewährleisten.

Voranstehende Aufgabe wird gelöst durch ein Gehäuse mit den Merkmalen des Anspruchs 1, ein Schaltbauteil mit den Merkmalen des Anspruchs 8 sowie ein Verfahren mit den Merkmalen des Anspruchs 9. Weitere Merkmale und Details der Erfindung ergeben sich aus den Unteransprüchen, der Beschreibung und den Zeichnungen. Dabei gelten Merkmale und Details, die im Zusammenhang mit dem erfindungsgemäßen Gehäuse beschrieben sind, selbstverständlich auch im Zusammenhang mit dem erfindungsgemäßen Schaltbauteil sowie dem erfindungsgemäßen Verfahren und jeweils umgekehrt, sodass bzgl. der Offenbarung zu den einzelnen Erfindungsaspekten stets wechselseitig Bezug genommen wird bzw. werden kann.

Erfindungsgemäß ist ein Gehäuse für wenigstens ein ein elektromechanisches Schaltbauteil zur Anbringung in oder an einem Fahrzeug, vorgesehen. Das Gehäuse weist eine Gehäusewand auf, welche einen Gehäuseinnenraum umgibt. Das Gehäuse zeichnet sich erfindungsgemäß dadurch aus, dass an der Gehäusewand wenigstens ein nach außen gerichtetes Kontaktelement angeordnet ist mit wenigstens einer Kontaktfläche zur befestigenden Kontaktierung an einer Gegenkontaktfläche. Die Gegenkontaktfläche ist dabei vorzugsweise Teil der Karosserie des Fahrzeugs.

Ein erfindungsgemäßes Gehäuse dient also dazu, elektrische Bauteile bzw. elektromechanische Schaltbauteile zu schützen. Dafür ist die Gehäusewand bzw. ein Teil der Gehäusewand vorzugsweise wasserundurchlässig ausgebildet. Auch kann das Gehäuse weitere Bauteile, insbesondere in Form von Dichtmitteln aufweisen, um das gesamte Gehäuse wasserdicht oder im Wesentlichen wasserdicht mit Bezug auf den Gehäuseinnenraum auszubilden. Dabei ist darauf hinzuweisen, dass für möglicherweise notwendige Druckausgleichssituationen selbstverständlich die Gehäusewand oder andere Bauteile des Gehäuses einen entsprechenden Druckausgleich, z. B. mit Hilfe einer Entlüftungsöffnung zulassen.

Der Gehäuseinnenraum dient demnach als Aufnahmeraum für das elektrische Bauteil. Erfindungsgemäß handelt es sich bei dem elektrischen Bauteil um ein elektromechanisches Schaltbauteil, welches eine mechanische Betätigung in ein elektrisches Signal umwandeln kann. Dies ist z. B. für die Entriegelung und den Öffnungsvorgang in automatisierter Weise für die Heckklappe eines Fahrzeugs denkbar. So kann z. B. ein erfindungsgemäßes Gehäuse einen entsprechenden Kontaktschalter als mechanisches Schaltbauteil für das Öffnen der Heckklappe aufweisen. Das Gehäuse, welches in seinem Gehäuseinnenraum das wenigstens eine elektrische Bauteil aufweist, muss dementsprechend an der Karosserie an der gewünschten Position an der Heckklappe befestigt werden.

Bei dem voranstehend beschriebenen Beispiel wird der erfindungsgemäße Vorteil besonders klar deutlich. So muss nun nicht mehr in aufwendiger Weise eine Verschraubung des fertig gestellten Gehäuses, also des Gehäuses mit dem darin aufgenommen elektrischen Bauteil, mit der Karosserie erfolgen. Vielmehr kann durch das Vorhandensein des von der Gehäusewand nach außen gerichteten Kontaktelements eine einfache Kontaktierung der Kontaktfläche mit der Gegenkontaktfläche erfolgen. Damit entsteht die befestigende Kontaktierung ohne zusätzliche Mittel, insbesondere ohne zusätzliche Verschraubung.

Unter einem Kontaktelement mit wenigstens einer Kontaktfläche ist dabei jedes Element zu verstehen, was eine befestigende Wirkung bei der Kontaktierung zwischen der Kontaktfläche und der Gegenkontaktfläche ermöglicht. Zwei bevorzugte Lösungen für ein Kontaktelement mit Kontaktflächen sind nachfolgend beschreiben. So kann das Kontaktelement insbesondere als Klebeelement mit wenigstens einer Klebefläche ausgebildet sein, sodass die befestigende Kontaktierung eine Verklebung mit der Gegenkontaktfläche darstellt. Erfindungsgemäß ist das Kontaktelement als Rastelement ausgebildet, wobei dieses eine Rastfläche zur verrasteten befestigten Kontaktierung einer Gegenkontaktfläche in Form einer Gegenrastfläche ausbildet.

Die beiden voranstehenden Beispiele für Kontaktelemente sind eine nicht abschließende Liste, und dementsprechend nicht einschränkend für den Schutzbereich der vorliegenden Anmeldung. Wie aus diesen Beispielen deutlich wird, wird durch ein erfindungsgemäßes Gehäuse eine einfache, schnelle und damit vor allem kostengünstige Montage des Gehäuses an der Karosserie des Fahrzeugs möglich. Auch ist dieser Montagevorgang leichter und vor allem risikoärmer durchzuführen, als dies bei einer Verschraubung der Fall ist. Dementsprechend kann auch eine zusätzliche Öse für eine zusätzliche Schraube unterbleiben, sodass ein erfindungsgemäßes Gehäuse kleiner und vor allem auch leichter ausgebildet werden kann.

Bei einem erfindungsgemäßen Gehäuse ist das wenigstens eine Kontaktelement als Rastelement ausgebildet mit wenigstens einer Kontaktfläche in Form einer Rastfläche zur verrastenden Kontaktierung mit einer Gegenkontaktfläche in Form einer Gegenrastfläche. Ein Rastelement dient also dazu, durch ein elastisches Verformen aus einer Rastposition in eine Freigabeposition eine Bewegung des Gehäuses in seine Montageposition zuzulassen. Befindet sich das Gehäuse in der Montageposition wird durch elastische Rückstellkräfte innerhalb des Rastelements dieses aus seiner Freigabeposition wieder in seine Rastposition bewegt, sodass nun die Rastfläche mit der Gegenrastfläche an der Karosserie eine verrastende Kontaktierung ausbildet. Mit anderen Worten wird ein Gehäuse dieser erfindungsgemäßen Ausführungsform einfach, kostengünstig und vor allem schnell in eine entsprechende Rastöffnung der Karosserie eingedrückt und verrastet. Diese Lösung kann selbstverständlich mit Kontaktelementen anderer technischer Ausführungsformen kombiniert werden. Insbesondere ist eine Kombination mit einem Verkleben möglich, wie es nachfolgend beschrieben wird. Auch kann ein Kontaktelement zwei oder mehr Funktionalitäten aufweisen. So kann beispielsweise die Rastfläche des Rastelements gleichzeitig mit einem Kleber versehen sein und damit auch als Klebefläche in Form einer Kontaktfläche wirken.

Erfindungsgemäß ist es weiter von Vorteil, wenn bei einem erfindungsgemäßen Gehäuse das wenigstens eine Kontaktelement als Klebeelement ausgebildet ist mit wenigstens einer Kontaktfläche in Form einer Klebefläche zur klebenden Kontaktierung mit einer Gegenkontaktfläche in Form einer Gegenklebefläche. Wie bereits im voranstehenden Absatz erläutert, ist dies eine weitere Möglichkeit die Kontaktierungen befestigender Weise zur Verfügung zu stellen. Auch die im voranstehenden Absatz beschriebene Kombinationsmöglichkeit verschiedener Elemente bzw. verschiedener Kontaktfunktionalitäten in einem Kontaktelement ist selbstverständlich möglich. Die Oberfläche der Klebefläche ist dabei vorzugsweise mit Klebstoff bearbeitet bzw. versehen. Dafür kann die Oberflächenstruktur vorbereitet sein, insbesondere aufgeraut, um eine verbesserte Klebewirkung zu erzielen. Auch kann die Klebefläche selbst den Klebstoff aufweisen, um z. B. über Druckaktivierung oder Hitzeaktivierung die Klebewirkung zu aktivieren.

Bei einem erfindungsgemäßen Gehäuse ist an der Gehäusewand ein nach außen gerichtetes flexibles Ausgleichselement angeordnet, welches das wenigstens eine Kontaktelement zumindest abschnittsweise umgibt. Ein flexibles Ausgleichselement ist dabei auf den Ausgleich in elastisch verformender Weise des eigenen Materials für geometrische Unterschiede zwischen der Gehäusewand und der anliegenden Karosserie ausgebildet. So wird es häufig vorkommen, dass durch Toleranzunterschiede die Karosserie bzw. die Gehäusewand des erfindungsgemäßen Gehäuses nicht plan aneinander liegen würden. Dies könnte möglicherweise zu einer Reduktion der Befestigungswirkung der Kontaktelemente führen. Um dies zu vermeiden, kann ein flexibles Ausgleichselement vorgesehen werden, welches durch flexible und damit elastische Verformung seines eigenen Materials solche Ungleichheiten und Toleranzen ausgleichen kann. Insbesondere ist ein solches flexibles Ausgleichselement auch als Dichtelement wirksam bzw. ausgebildet. Nicht zuletzt kann auf diese Weise eine Beschichtung des Karosseriebauteils, an welchem das Gehäuse befestigt wird, geschützt werden. Ist beispielsweise ein Lack oder eine anders geartete Schutzbeschichtung auf der Karosserie vorgesehen, so kann das flexible Ausgleichselement durch seine elastische Verformbarkeit einen Schutz zur Verfügung stellen. Das flexible Ausgleichselement kann z. B. in Form eines Ausgleichspads im Wesentlichen flächig ausgebildet sein. Insbesondere weist das flexible Ausgleichselement ein Kunststoffmaterial auf. Für die Montage ist das flexible Ausgleichselement insbesondere zumindest temporär an der Gehäusewand befestigt. Zum Beispiel kann eine einfache Verklebung vorgesehen sein, dass für die kontaktierende Befestigung die Anordnung des flexiblen Ausgleichselements mit hoher Wahrscheinlichkeit auch an der gewünschten Position verbleibt. Das Ausgleichselement kann dabei mit dem Kontaktelement vorzugsweise eine bauliche Einheit bilden. Insbesondere können Ausgleichselement und Kontaktelement integral miteinander, also einstückig bzw. monolithisch, ausgebildet sind.

Es ist ebenfalls von Vorteil, wenn bei einem erfindungsgemäßen Gehäuse das Ausgleichselement eine Dicke aufweist, welche derart mit der Kontaktfläche korreliert, dass bei befestigender Kontaktierung der Gegenkontaktfläche durch die Kontaktfläche des Kontaktelements eine Dichtkraft, insbesondere in elastisch verformender Weise, auf das Ausgleichselement einwirkt. Mit anderen Worten bilden die geometrische Korrelation zwischen Gegenkontaktfläche und Kontaktfläche sowie der Dicke des Ausgleichselementes eine finale Montagesituation, welche vorzugsweise zu einer elastisch verformten Reduktion der Dicke des Ausgleichselements in der Montagesituation führt. Mit anderen Worten wirkt in der montierten Situation eine Dichtkraft auf das Ausgleichselement, sodass nun eine Abdichtung eines entsprechenden Montagelochs bzw. einer entsprechenden Montageöffnung in der Karosserie gegen das Eindringen von Wasser vorliegt. Dies führt zu einer Reduktion von Korrosionsgefahr von diesem Karosseriebereich.

Ein weiterer Vorteil kann erzielt werden, wenn bei einem erfindungsgemäßen Gehäuse das Ausgleichselement ringförmig ausgebildet ist und das wenigstens eine Kontaktelement umgibt. Das Umgeben kann dabei unterschiedlichste Geometrien aufweisen. Insbesondere kann das Ausgleichselement rund, eckig oder mit einer anderen ringförmigen Form das Kontaktelement umgeben. Bevorzugt werden alle Kontaktelemente einzeln bzw. alle Kontaktelemente gemeinsam vollständig von einem oder mehreren Ausgleichselementen umgeben. Dies führt sozusagen zu einer Abdichtung um alle Kontaktelemente herum. Da üblicherweise für jedes Kontaktelement bzw. für alle Kontaktelemente gemeinsam eine entsprechende Gegenkontaktöffnung innerhalb der Karosserie vorgesehen ist, wirkt eine derartige Ausführungsform abdichtend auch gegen diese Gegenkontaktöffnung der Karosserie.

Bei einem erfindungsgemäßen Gehäuse weist das Ausgleichselement eine Ausbildung als Klebeband mit einer Schaumstoffzwischenschicht auf.

Vorteilhaft ist es weiter, wenn bei einem erfindungsgemäßen Gehäuse das Ausgleichselement wenigstens eine der folgenden Ausbildungen aufweist:
- Schaumstoff, insbesondere wasserfester Schaumstoff
- Silikonelement
- Gummielement

Bei der voranstehenden Aufzählung handelt es sich um eine nicht abschließende Liste. Selbstverständlich können auch unterschiedliche Ausgleichselemente miteinander kombiniert werden, um ein oder mehrere erfindungsgemäße Ausgleichselemente auszubilden. Dabei können auch unterschiedliche Formen der Ausgleichselemente kombiniert werden. Ist das Ausgleichselement als Klebeband ausgebildet, so kann dieses einseitig oder auch zweiseitig klebend ausgebildet sein. Insbesondere ist in einem solchen Fall das Ausgleichselement als bauliche Einheit mit dem Kontaktelement ausgebildet, sodass die Klebefunktion gleichzeitig die befestigende Kontaktierungsfunktion ausbildet.

Vorteilhaft ist es weiter, wenn bei einem erfindungsgemäßen Gehäuse das Gehäuse wenigstens eines der folgenden Bauteile in seinem Gehäuseinnenraum aufweist:
- Taster
- Schalter
- Sensor, insbesondere kapazitiver und/oder optischer Sensor
- Beleuchtungselement

Bei der voranstehenden Aufzählung handelt es sich um eine nicht abschließende Liste. Als Beleuchtungselement kann z. B. eine LED oder ein externer Lichtleiter eingesetzt werden, um eine Beleuchtung des Gehäuseinnenraums bzw. nach außen durch teiltransparente oder transparente Ausbildung der Gehäusewand vorzunehmen. Sensoren sind in der Lage die Annäherung von Personen oder Körperteilen von Personen kapazitiv oder optisch wahrzunehmen. Der Schalter selbst ist in der Lage eine Betätigung durchzuführen und dabei insbesondere ein elektrisches Signal auszulösen bzw. zu verwenden. Beispielsweise kann eine Kopplung des Sensors mit dem Beleuchtungselement vorliegen, sodass bei Erkennung der Annäherung eines Körperteils des Benutzers oder des gesamten Benutzers, das Beleuchtungselement das Gehäuse von innen heraus beleuchtet. Dies führt zu einer erleichterten Auffindbarkeit, insbesondere bei kleinen oder versteckt angeordneten Gehäusen an der Karosserie.

Vorteilhaft ist es darüber hinaus, wenn bei einem erfindungsgemäßen Gehäuse die Gehäusewand wenigstens eine Kabeldurchführung aufweist, welche eine Führung eines hindurchgeführten Kabels zur Vermeidung von Knickstellen und/oder Scheuerstellen ausbildet. Dabei ist die Kabelführung insbesondere wenigstens abschnittsweise durch das wenigstens eine Kontaktelement ausgebildet. Die Kabeldurchführung dient also dazu eine Stromversorgung bzw. eine Signalkommunikation zwischen dem Gehäuseinnenraum und einer externen Versorgungseinheit bzw. einer externen Kontrolleinheit zu ermöglichen. Kabel, könnten dabei als Signalkabel, als Kommunikationskabel und/oder auch als Energieversorgungskabel ausgebildet sein. Dabei dient die Kabeldurchführung dazu, insbesondere eine Wasserdichtigkeit des Gehäuseinnenraums zu gewährleisten. Weiter kann durch die Kabeldurchführung wenigstens abschnittsweise durch das Kontaktelement eine Führung der Kabel hinter das Karosserieelement zulassen, an welchem das Gehäuse befestigt werden soll. Bevorzugt ist es, wenn die einzelnen Kabel eine Kontaktfläche im elektrischen Sinn an dem jeweiligen Kontaktelement aufweisen, sodass in entsprechender Weise zur kontaktierenden Befestigung auch eine automatische oder im Wesentlichen automatische elektrische Kontaktierung zwischen der elektrischen Kontaktfläche und einer elektrischen Gegenkontaktfläche stattfinden kann.

Ebenfalls Gegenstand der vorliegenden Erfindung ist ein Schaltbauteil mit einem Gehäuse, aufweisend die Merkmale der vorliegenden Erfindung, wobei im Gehäuseinnenraum wenigstens ein elektrisches Bauteil angeordnet ist. Damit bringt ein erfindungsgemäßes Schaltbauteil die gleichen Vorteile mit sich, wie sie ausführlich mit Bezug auf ein erfindungsgemäßes Gehäuse erläutert worden sind. Insbesondere ist das Schaltbauteil einzusetzen für eine Befestigung an der Karosserie des Fahrzeugs, z. B. im Innenraum oder an der Außenseite.

Ein weiterer Gegenstand der vorliegenden Erfindung ist ein Verfahren für die Befestigung eines Schaltbauteils gemäß der vorliegenden Erfindung, an der Karosserie eines Fahrzeugs, aufweisend die folgenden Schritte:
- Kontaktieren einer Gegenkontaktfläche mit wenigstens einer Kontaktfläche eines Kontaktelements des Gehäuses, des Schaltbauteils und der Ausbildung einer Befestigung.

Ein erfindungsgemäßes Verfahren bringt dementsprechend die gleichen Vorteile mit sich, wie sie ausführlich mit Bezug auf ein erfindungsgemäßes Gehäuse erläutert worden sind. Die entsprechende Öffnung für die Aufnahme der Kontaktelemente des Gehäuses kann auch als Gegenkontaktöffnung bezeichnet werden und ist vorzugsweise Teil einer Kabeldurchführung in den Innenraum hinter der Karosserie.

Ein weiterer Gegenstand der vorliegenden Erfindung ist ein Fahrzeug, insbesondere ein Kraftfahrzeug, aufweisend wenigstens ein erfindungsgemäßes Schaltbauteil.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen schematisch:
- Fig. 1: eine erste Ausführungsform eines erfindungsgemäßen Schaltbauteils bei der Montage,
- Fig. 2: die Ausführungsform der Figur 1 nach der Montage,
- Fig. 3: eine weitere Ausführungsform eines erfindungsgemäßen Gehäuses bei der Montage,
- Fig. 4: die Ausführungsform der Figur 3 nach der Montage,
- Fig. 5: eine weitere Ausführungsform eines erfindungsgemäßen Gehäuses,
- Fig. 6: eine Ausführungsform eines Ausgleichselements und
- Fig. 7: eine weitere Ausführungsform eines Ausgleichselements.

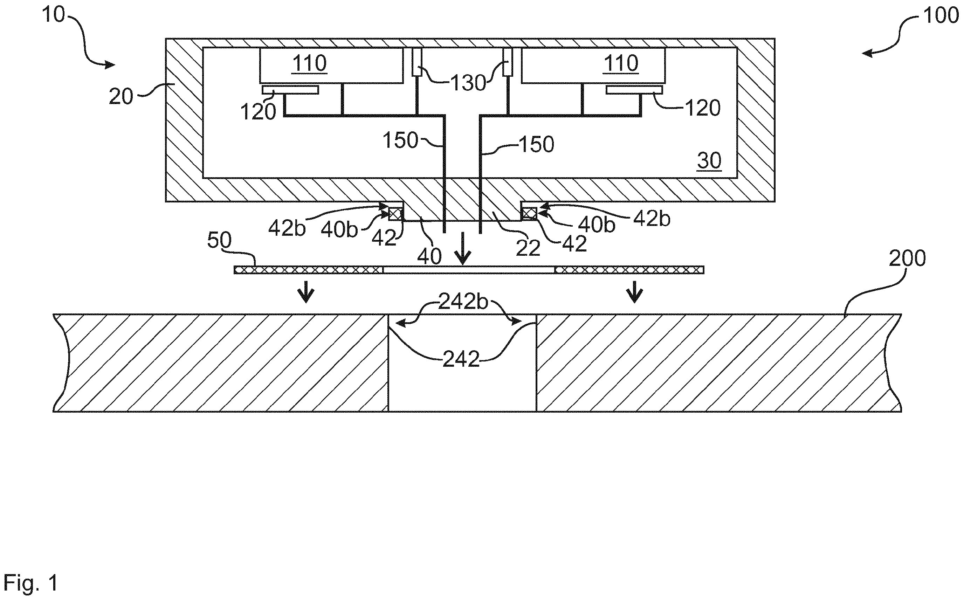

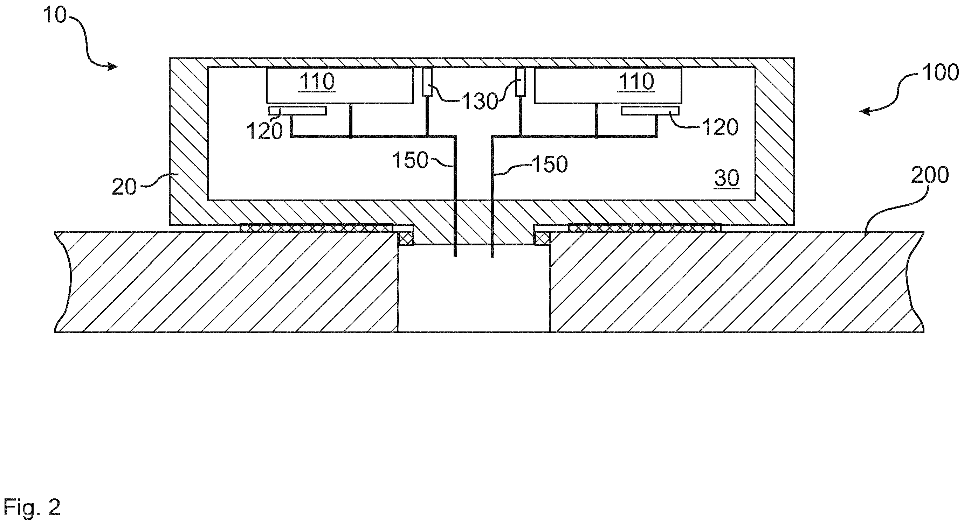

Die Figuren 1 und 2 zeigen eine erste Ausführungsform eines erfindungsgemäßen Gehäuses 10, in welchem verschiedenste Bauteile 100 angeordnet sind. Im Gehäuseinnenraum 30, welcher von einer umgebenden Gehäusewand 20 abgeschlossen wird, sind hier zwei Schalter 110 als elektromechanische Bauteile ausgebildet. Zusätzlich sind für jeden Schalter 110 jeweils ein Sensor 130 und ein Beleuchtungselement 120 vorgesehen. Um eine entsprechende elektrische Kontaktierung zur Energieversorgung und Signalkommunikation zur Verfügung zu stellen, sind Kabel 150 vorgesehen, welche im Gehäuseinnenraum 30 zu den einzelnen Bauteilen 100 verlaufen.

Das Gehäuse 10 soll an der Karosserie 200 eines Fahrzeugs befestigt werden. Hierfür ist eine Durchgangsöffnung als Gegenkontaktöffnung vorgesehen, welche bei dieser Ausführung Gegenkontaktflächen 242 in Form von Gegenklebeflächen 242b aufweist.

In Figur 1 ist die Montagesituation dargestellt. So wird zwischen das Gehäuse 10 und die Karosserie 200 ein Ausgleichselement 50 für einen elastischen Toleranzausgleich eingesetzt. Darüber hinaus weist die Gehäusewand 20 an der Außenseite Kontaktelemente 40 in Form von Klebeelementen 40b auf, welche Kontaktflächen 42 in Form von Klebeflächen 42b aufweisen. Der Pfeil in der Mitte bzw. die beiden Pfeile für das Ausgleichselement 50 zeigen die Montagerichtung an. Nach der Montage befindet sich das Gehäuse 10 in einer Position gemäß Figur 2, in welcher die Kontaktflächen 42 des Gehäuses 10 die Gegenkontaktflächen 242 in klebender und damit befestigender Weise kontaktieren. Das Ausgleichselement 50 ist zumindest teilweise elastisch verformt und bildet auf diese Weise mit der einwirkenden Dichtkraft eine Dichtwirkung aus. Die Kabel 150 sind durch eine entsprechende Kabeldurchführung 22 als Teil der Kontaktelemente 40 hindurchgeführt und können nun von der Innenseite der Karosserie 200, also in Figur 2 von unten, elektrisch kontaktiert werden.

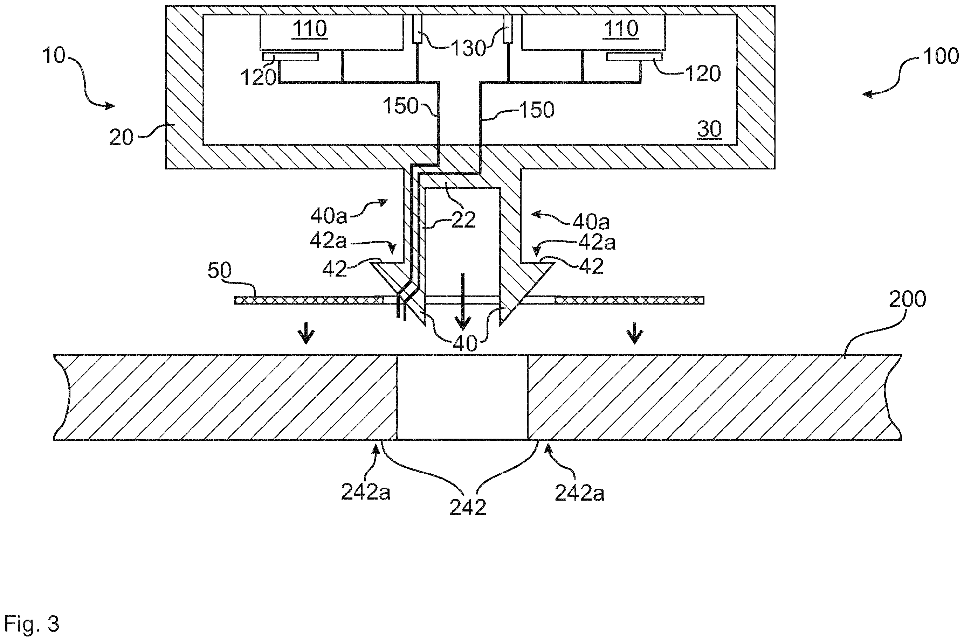

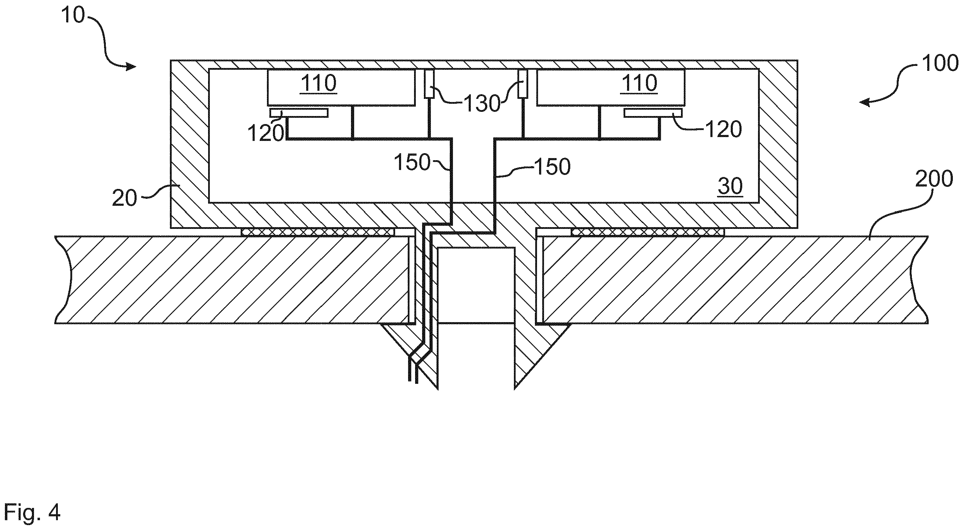

Figur 3 und 4 zeigen eine alternative Ausführungsform eines erfindungsgemäßen Gehäuses 10. Auch hier sind Bauteile 100 in Form von Schaltern 110, Beleuchtungselementen 120 und Sensoren 130 im Gehäuseinnenraum 30 angeordnet. Jedoch ist hier für die Befestigung des Gehäuses 10 an der Karosserie 200 eine Ausbildung der Kontaktelemente 40 als Rastelemente 40a ausgebildet vorgesehen. Dementsprechend sind die hier dargestellten zwei Kontaktflächen 42 auch als Rastflächen 42a ausgebildet. Dementsprechend sind auf der gegenüberliegenden Seite der Karosserie 200 hinter der Gegenkontaktöffnung die Gegenkontaktflächen 242 als Gegenrastflächen 242a ausgebildet. Die Montage verläuft in gleicher Weise, sodass in Figur 4 die befestigte Situation zu erkennen ist. Bei dieser Ausführungsform verlaufen die Kabel 150 entlang der Kabeldurchführung 22 durch das komplette Kontaktelement 40 auf der linken Seite. Auch hier kann nun eine elektrische Kontaktierung dieser Kabel 150 von der Innenseite der Karosserie 200, also von unten gemäß Figur 4, erfolgen.

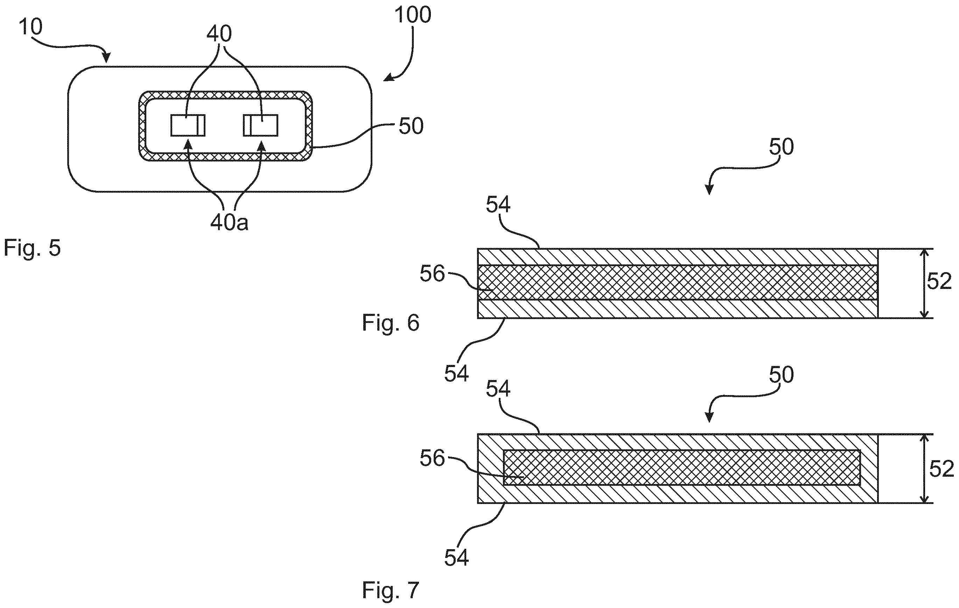

In Figur 5 ist eine weitere Ausführungsform eines erfindungsgemäßen Gehäuses 10 von unten dargestellt. Hier ist gut zu erkennen, dass das Bauteil 100 eine umgebende bzw. ringförmig umlaufende Ausbildung des Ausgleichselements 50 um die beiden Kontaktelemente 40 aufweist, welche hier als Rastelemente 40a ausgebildet sind. Damit wird es möglich eine umlaufende Abdichtung mit der bereits erläuterten Dichtfunktion zu erzielen.

Die Figuren 6 und 7 zeigen zwei unterschiedliche Möglichkeiten, ein Ausgleichselement 50 zur Verfügung zu stellen. Hier sind mehrlagige Materialen verwendet. So ist zwischen zwei Klebeflächen 54 hier ein Schaumstoff 56 vorgesehen. Dieser Schaumstoff 56 dient dazu die gewünschte Flexibilität zur Verfügung zu stellen, um eine elastische Verformbarkeit beim Einwirken einer Dichtkraft zu ermöglichen. Die Dicke 52 des jeweiligen Ausgleichselements 50 ist dabei so dimensioniert, dass bei der Montage gemäß der Figuren 1 und 2 bzw. 3 und 4 ein elastisches Zusammenpressen erfolgt, sodass auch die gewünschte Dichtkraft für eine Reduktion der Dicke 52 vorliegt.

Die voranstehende Erläuterung der Ausführungsformen beschreibt die vorliegende Erfindung ausschließlich im Rahmen von Beispielen. Selbstverständlich können einzelne Merkmale, sofern technisch sinnvoll, frei miteinander kombiniert werden, ohne den Rahmen der vorliegenden Erfindung zu verlassen.

### Bezugszeichenliste

- 10: Gehäuse

- 20: Gehäusewand
- 22: Kabeldurchführung

- 30: Gehäuseinnenraum

- 40: Kontaktelement
- 40a: Rastelement
- 40b: Klebeelement
- 42: Kontaktfläche
- 42a: Rastfläche
- 42b: Klebefläche

- 50: Ausgleichselement
- 52: Dicke
- 54: Klebefläche
- 56: Schaumstoff

- 100: Bauteil
- 110: Schalter
- 120: Beleuchtungselement
- 130: Sensor
- 150: Kabel

- 200: Karosserie
- 242: Gegenkontaktfläche
- 242a: Gegenrastfläche
- 242b: Gegenklebefläche

## Patentansprüche

1. Gehäuse (10) für wenigstens ein elektromechanisches Schaltbauteil, zur Anbringung in oder an einem Fahrzeug, aufweisend eine Gehäusewand (20), welche einen Gehäuseinnenraum (30) umgibt, welches in seinem Gehäuseinnenraum (30) das elektromechanische Schaltbauteil aufweist,
**dadurch gekennzeichnet,**
**dass** an der Gehäusewand (20) wenigstens ein nach Außen gerichtetes Kontaktelement (40) angeordnet ist mit wenigstens einer Kontaktfläche (42) zur befestigenden Kontaktierung mit einer Gegenkontaktfläche (242), wobei das wenigstens eine Kontaktelement (40) als Rastelement (40a) ausgebildet ist mit wenigstens einer Kontaktfläche (42) in Form einer Rastfläche (42a) zur verrastenden Kontaktierung mit einer Gegenkontaktfläche (242) in Form einer Gegenrastfläche (242a), wobei an der Gehäusewand (20) ein nach Außen gerichtetes flexibles Ausgleichselement (50) angeordnet ist, welches das wenigstens eine Kontaktelement (40) zumindest abschnittsweise umgibt, wobei das Ausgleichselement (50) als Klebeband mit einer Schaumstoffzwischenschicht ausgebildet ist.

2. Gehäuse (10) nach einem der vorangegangenen Ansprüche,
**dadurch gekennzeichnet,**
**dass** das wenigstens eine Kontaktelement (40) als Klebeelement (40b) ausgebildet ist mit wenigstens einer Kontaktfläche (42) in Form einer Klebefläche (42b) zur klebenden Kontaktierung mit einer Gegenkontaktfläche (242) in Form einer Gegenklebefläche (242b).

3. Gehäuse (10) nach einem der vorangegangenen Ansprüche,
**dadurch gekennzeichnet,**
**dass** das Ausgleichselement (50) eine Dicke (52) aufweist, welche derart mit der Kontaktfläche (42) korreliert, dass bei befestigender Kontaktierung der Gegenkontaktfläche (242) durch die Kontaktfläche (42) des Kontaktelements (40) eine Dichtkraft, insbesondere in elastisch verformender Weise, auf das Ausgleichselement (50) einwirkt.

4. Gehäuse (10) nach einem der vorangegangenen Ansprüche,
**dadurch gekennzeichnet,**
**dass** das Ausgleichselement (50) ringförmig ausgebildet ist und das wenigstens eine Kontaktelement (40) umgibt.

5. Gehäuse (10) nach einem der Ansprüche nach einem der vorangegangenen Ansprüche,
**dadurch gekennzeichnet,**
**dass** das Ausgleichselement (50) wenigstens eine der folgenden Ausbildungen aufweist:
- Schaumstoff, insbesondere wasserfester Schaumstoff
- Silikonelement
- Gummielement

6. Gehäuse (10) nach einem der vorangegangenen Ansprüche,
**dadurch gekennzeichnet,**
**dass** das Gehäuse (10) wenigstens eines der folgenden Bauteile (100) in seinem Gehäuseinnenraum (30) aufweist:
- Taster
- Schalter (110)
- Sensor (130), insbesondere kapazitiver und/oder optischer Sensor
- Beleuchtungselement (120)

7. Gehäuse (10) nach einem der vorangegangenen Ansprüche,
**dadurch gekennzeichnet,**
**dass** die Gehäusewand (20) wenigstens eine Kabeldurchführung (22) aufweist, welche eine Führung eines hindurchgeführten Kabels (150) zur Vermeidung von Knickstellen und/oder Scheuerstellen ausbildet, wobei die Kabelführung (22) insbesondere wenigstens abschnittsweise durch das wenigstens eine Kontaktelement (40) ausgebildet ist.

8. Schaltbauteil mit einem Gehäuse (10), aufweisend die Merkmale eines der Ansprüche 1 bis 7, wobei im Gehäuseinnenraum (30) wenigstens ein elektrisches Bauteil (100) angeordnet ist.

9. Verfahren für die Befestigung eines Schaltbauteils mit den Merkmalen des Anspruchs 8, an der Karosserie (200) eines Fahrzeugs, aufweisend die folgenden Schritte:
- Kontaktieren einer Gegenkontaktfläche (242) mit wenigstens einer Kontaktfläche (42) eines Kontaktelements (40) des Gehäuses (10) des Schaltbauteils (100) unter Ausbildung einer Befestigung.

## Claims

1. Housing (10) for at least one electromechanical switching component, for mounting in or on a vehicle, comprising a housing wall (20), which surrounds a housing interior (30), which has the electromechanical switching component in its housing interior (30),
**characterised in that**
there is arranged on the housing wall (20) at least one outwardly directed contact element (40) with at least one contact surface (42) for fastening contact with a mating contact surface (242), wherein the at least one contact element (40) is formed as a latching element (40a) with at least one contact surface (42) in the form of a latching surface (42a) for latching contact with a mating contact surface (242) in the form of a mating latching surface (242a), wherein there is arranged on the housing wall (20) an outwardly directed flexible compensation element (50), which surrounds the at least one contact element (40) at least in sections, wherein the compensation element (50) is formed as an adhesive strip with an intermediate layer of foamed material.

2. Housing (10) according to one of the previous claims,
**characterised in that**
the at least one contact element (40) is formed as an adhesive element (40b) with at least one contact surface (42) in the form of an adhesive surface (42b) for adhesive contact with a mating contact surface (242) in the form of a mating adhesive surface (242b).

3. Housing (10) according to any one of the previous claims,
**characterised in that**
the compensation element (50) has a thickness (52) that correlates in such a way with the contact surface (42) that in fastening contact of the mating contact surface (242) by the contact surface (42) of the contact element (40), a sealing force, in particular in an elastically deforming manner, acts on the compensation element (50).

4. Housing (10) according to any one of the previous claims,
**characterised in that**
the compensation element (50) is formed to be annular and surrounds the at least one contact element (40).

5. Housing (10) according to any one of the previous claims,
**characterised in that**
the compensation element (50) has at least one of the following forms:
- foamed material, in particular water-resistant foamed material
- silicone element
- rubber element.

6. Housing (10) according to any one of the previous claims,
**characterised in that**
the housing (10) has at least one of the following components (100) in its housing interior (30):
- push button
- switch (110)
- sensor (130), in particular capacitive and/or optical sensor
- lighting element (120).

7. Housing (10) according to any one of the previous claims,
**characterised in that**
the housing wall (20) has at least one cable bushing (22), which forms a duct of a cable (150) led through to avoid kinks and/or abrasion points, wherein the cable duct (22) is formed in particular, at least in sections, by the at least one contact element (40).

8. Switching component with a housing (10), comprising the features of any one of claims 1 to 7, wherein at least one electrical component (100) is arranged in the housing interior (30).

9. Method for fastening a switching component with the features of claim 8 to the bodywork (200) of a vehicle, having the following steps:
- contacting of a mating contact surface (242) by at least one contact surface (42) of a contact element (40) of the housing (10) of the switching component (100) with the formation of a fastening.

## Revendications

1. Boîtier (10) pour au moins un composant électromécanique de commutation, destiné à une pose dans ou sur un véhicule, comportant une paroi de boîtier (20) entourant un espace intérieur de boitier (30), et ledit boitier, dans son espace intérieur de boîtier (30) présentant le composant électromécanique de commutation,
**caractérisé en ce qu'**
au moins un élément de contact (40) orienté vers l'extérieur est disposé sur la paroi de boîtier (20) avec au moins une surface de contact (42) pour une mise en contact de fixation avec une surface de contact antagoniste (242),
l'au moins un élément de contact (40) étant conçu comme un élément d'encliquetage (40a) avec au moins une surface de contact (42) sous forme de surface d'encliquetage (42a) pour une mise en contact par encliquetage avec une surface de contact antagoniste (242) sous forme de surface d'encliquetage antagoniste (242a), un élément de compensation (50) flexible tourné vers l'extérieur, lequel entoure au moins partiellement ledit au moins élément de contact (40) étant disposé sur la paroi de boîtier (20), l'élément de compensation (50) étant conçu sous la forme d'une bande adhésive avec une couche intermédiaire en mousse.

2. Boîtier (10) selon l'une quelconque des revendications précédentes,
**caractérisé en ce**
**que** l'au moins un élément de contact (40) est conçu comme élément adhésif (40b) avec au moins une surface de contact (42) sous forme d'une surface adhésive (42b) pour une mise en contact par collage avec une surface de contact antagoniste (242) sous forme d'une surface adhésive antagoniste (242b).

3. Boîtier (10) selon l'une quelconque des revendications précédentes,
**caractérisé en ce que**
l'élément de compensation (50) présente une épaisseur (52) qui est en corrélation avec la surface de contact (42) de telle sorte qu'une force d'étanchéité agit sur l'élément de compensation (50), en particulier de manière à déformation élastique, lors de la mise en contact de fixation de la surface de contact antagoniste (242) avec la surface de contact (42) de l'élément de contact (40).

4. Boîtier (10) selon l'une quelconque des revendications précédentes,
**caractérisé en ce que**
l'élément de compensation (50) est conçue de forme annulaire et **en ce qu'**il entoure l'au moins un élément de contact (40).

5. Boîtier (10) selon l'une quelconque des revendications précédentes,
**caractérisé en ce que**
l'élément de compensation (50) au moins l'un des configurations suivants :
- Mousse, plus particulièrement de la mousse résistante à l'eau
- Élément en silicone
- Élément en caoutchouc

6. Boîtier (10) selon l'une quelconque des revendications précédentes,
**caractérisé en ce que**
le boîtier (10) présente au moins un des composants (100) suivants dans son espace intérieur du boîtier (30) :
- Bouton-poussoir
- Commutateur (110)
- Capteur (130), en particulier un capteur capacitif et/ou optique
- Élément d'éclairage (120)

7. Boîtier (10) selon l'une quelconque des revendications précédentes,
**caractérisé en ce que**
la paroi de boîtier (20) comporte au moins une traversée de câbles (22), qui forme une guidage d'un câble (150) guidé à travers afin d'éviter des pliures et/ou des points de friction, la traversée de câbles (22) étant formée, notamment au moins en partie, par l'au moins un élément de contact (40).

8. Composant de commutation avec un boîtier (10) présentant les caractéristiques de l'une des revendications 1 à 7, au moins un composant électrique (100) étant disposé dans l'espace intérieur du boîtier (30).

9. Procédé destiné à la fixation d'un composant de commutation avec les caractéristiques de la revendication 8 sur la carrosserie (200) d'un véhicule, comprenant les étapes suivantes :
- Mise en contact d'une surface de contact antagoniste (242) avec au moins une surface de contact (42) d'un élément de contact (40) du boîtier (10) du composant de commutation (100) en formant une fixation.
